# EUROPEAN PATENT APPLICATION

(11) **EP 2 159 609 A1**
(43) Veröffentlichungstag der Anmeldung: **03.03.2010**
(21) Anmeldenummer: 07861012.8
(22) Anmeldetag: 15.06.2007
(51) Int. Cl.: G02B 3/08, B29D 11/00

(54) **VERFAHREN ZUR HERSTELLUNG EINES VERBUNDKONZENTRATOR-LINSENPANELS FÜR PHOTOVOLTAIKMODULE**

(71) Anmelder: Zakrytoe Aktsionernoe Obschestvo "Technoexan", Ul. Politekhnicheskaya, 26 St.Petersburg, 194021 (RU)
(72) Erfinder: ALFEROV, Zhores Ivanovich, St.Petersburg, 197343 (RU); ANDREEV, Vyacheslav Mikhailovich, St.Petersburg, 195256 (RU); RUMYANTSEV, Valery Dmitrievich, St.Petersburg, 194021 (RU); SADCHIKOV,Nikolai Anatolievich, St.Petersburg, 196066 (RU); LOVYGIN, Igor Vladimorivich, St.Petersburg, 197343 (RU)
(74) Vertreter: Jeck, Anton
(86) Internationale Anmeldenummer: PCT/RU2007/000324
(87) Internationale Veröffentlichungsnummer: WO 2008/153435

(57) **Zusammenfassung**

Die Erfindung betrifft ein Verfahren zur Herstellung einer Konzentratorlinsenplatte aus Verbundstoff für photoelektrische Module, das die Herstellung von negativen Fresnel-Linsen und die Fertigung von positiven Kopien derselben einschließt. Die Leistungsfähigkeit und die Wirtschaftlichkeit des Verfahrens wird **dadurch** erhöht und dabei eine hohe Lebensdauer der Linsenplatten und eine hohe Qualität der Fresnel-Linsen sichergestellt, wenn zuerst durch Diamantdrehens eine Art Negativ-Form mit hoher Qualität gebildet wird, die danach für ein wiederholtes Herstellen von Konzentratorlinsenplatte mit positiven Fresnel-Linsen verwendet wird.

## Beschreibung

Die Erfindung betrifft ein Verfahren zur Herstellung einer Konzentratorlinsenplatte aus Verbundstoff für photoelektrische Module, das die Herstellung von negativen Fresnel-Linsen und die Fertigung von positiven Kopien derselben einschließt.

Die Erfindung ist auf dem Gebiet der Solarenergie, insbesondere in Solarenergiesammler in photoelektrischen Modulen eingesetzt sind, anwendbar. Die Erfindung kann bei der Herstellung von Verbundstofflinsenplatten für photoelektrische Solarmodule, die in Konzentrator-Sonnenenergieanlagen eingebaut werden, besonders erfolgreich angewendet werden.

Die Anwendung von optischen Strahlungskonzentrationseinrichtungen in photoelektrischen Modulen ermöglicht es bekanntlich, die Energieeffizienz der photoelektrischen Module zu erhöhen und ihre Energie- und wirtschaftlichen Kenndaten zu verbessern, indem der Verbrauch von teuren Halbleiterwerkstoffen mehrfach verringert wird. So wird die Fläche der teuren Solarzellen beim 1000x-Sonnenstrahlungskonzentrationsgrad um das 1000-fache reduziert. Die aussichtsreichste Art der optischen Konzentratoren für Solarmodule sind flache Fresnel-Linsen.

Aus der JP3485620 ist ein Verfahren zur Herstellung einer Konzentratorlinsenplatte für photoelektrische Module bekannt, bei dem das Schmelzgut in eine Form mit einer Fresnel-Oberfläche eingegossen wird.

Die JP3310332 offenbart ein Verfahren zur Herstellung von Fresnel-Linsen und einer Konzentratorlinsenplatte für photoelektrische Solarmodule aus transparentem Kunststoff (Plexiglas) mittels Spritzgießens oder einer Thermoformung. Dabei werden Matrizen mit einem Negativprofil von Fresnel-Linsen eingesetzt. Die Fresnel-Linsen und die Linsenplatten werden auch unter Einsatz von transparenten Polymerwerkstoffen und Epoxydharzen mit einer Polymerisation durch UV-Strahlen gefertigt.

Ein Mangel der nach diesen Verfahren gefertigten Linsen ist ein großer Verlust im Zusammenhang mit der Aufnahme von Sonnenstrahlung in den Linsen aus Plexiglas und in den Linsen aus Kunststoffen und den UV-härtenden Harzen im Vergleich zu den Linsen, die mittels einer Silikonpolymerisation auf Glas hergestellt werden. Ein zweiter Mangel ist eine Degradation von Kunststoff, Polymeren und Harzen unter der Sonnenstrahlung. Das verursacht eine zusätzliche Absorption, was die optische Effektivität des Konzentrators herabsetzt. Darüber hinaus bedingen alle aufgezählten Verfahren zur Herstellung von Fresnel-Linsen Werkstoffschrumpfungen und folglich eine Verminderung der optischen Effektivität der hergestellten Fresnel-Linsen.

Aus der Patentanmeldung RU 2005109379 ist ein Verfahren zur Herstellung einer Konzentratorlinsenplatte aus Verbundstoff für photoelektrische Module bekannt, welches die Herstellung von negativen Fresnel-Linsen und eine Anfertigung von ihren positiven Kopien einschließt.

Die Nachteile dieses bekannten Verfahrens sind wie folgt: Hohe Herstellungskosten der Linsenplatten, weil dafür sehr viele teure Matrizen eingesetzt werden müssen, die nach einem Diamant-Mikrodreh-Verfahren hergestellt werden. Das macht eine Großserienproduktion der Linsenplatten für photoelektrische Solarmodule unmöglich.

Es ist Aufgabe der Erfindung, die Leistungsfähigkeit und die Wirtschaftlichkeit des Verfahrens zur Herstellung von Linsenplatten für photoelektrische Module zu erhöhen, wobei ihre lange Lebensdauer der Linsenplatten und eine hohe Qualität der Fresnel-Linsen sichergestellt ist.

Die gestellte Aufgabe wird durch die Merkmale des Anspruchs 1 gelöst.

Das technische Ergebnis wird auf folgende Weise erreicht:
Das Verfahren zur Herstellung einer Verbundstoff-Konzentratorlinsenplatte für photoelektrische Module schließt die Herstellung von negativen Fresnel-Linsen und die Fertigung ihrer positiven Kopien ein. Gemäß der Erfindung werden die mittels Diamantdrehens hergestellten negativen Fresnel-Linsen mit einer quadratischen Apertur an ihren Stirnseiten miteinander zu einer Baugruppe zusammengefügt. Danach wird eine Zwischenplatte gefertigt, indem die Baugruppe mit den negativen Fresnel-Linsen und einem über der Baugruppe angeordneten Silikatglas oder flexiblen Blattmaterial mit Zweikomponentensilikon ausgegossen wird. Danach wird eine Polymerisation des Zweikomponentensilikons durchgeführt. Danach wird die Zwischenplatte von der Baugruppe mechanisch getrennt. Die Zwischenplatte wird auf die Polyurethanmatrize mittels Polymerisation des Zweikomponentenpolyurethans kopiert. Die Polymerisation erfolgt im Umfang zwischen der Zwischenplatte und dem flachen Blattmaterial. Die hergestellte Polyurethanmatrize wird nach ihrem Biegen abgelöst. Danach wird die Polyurethanmatrize auf einer harten Grundlage befestigt und mit einer Zweikomponenten-Silikonmischung gefüllt. Die Dicke der Silikonschicht ist um mindestens 0,1 mm größer als die jeweilige Höhe von Profileinsenkungen der Fresnel-Linsen in der Polyurethanmatrize. Dabei wird über dem Silikon das Silikatglas mit dem auf seine Oberfläche aufgetragenen Primer angeordnet. Die überschüssige Silikonmischung wird ausgetrieben, bis eine Dicke von 0,1 mm erreicht ist. Danach erfolgt eine Polymerisation der Silikonmischung. Das Glas mit der Linsenplatte wird von der Polyurethanmatrize abgetrennt, indem die Matrize gebogen wird.

Als Material für negative mittels Diamantdrehens gefertigte Fresnel-Linsen kann ein Polymethylmethakrylat oder ein beliebiges korrosionsbeständiges Metall eingesetzt werden.

Als Material für die Matrize kann Polyurethan der Marke Por-A-Kast M15 oder ein beliebiges Polyurethan mit einer Gesamtschrumpfung nach der Polymerisation von max. einigen Prozentbruchteilen eingesetzt werden. Die Mischungspolymerisation wird im Laufe von 3 - 48 Stunden bei einer Temperatur von 20 - 50 °C durchgeführt.

Als Primer kann ein Grundierungsmittel Wacker oder eine beliebig andere Grundierung eingesetzt werden, die für eine Oberflächenbehandlung vorgesehen ist und zur Adhäsion von Silikonelastomeren dient.

Als Primer kann ein transparentes Einkomponenten-Silikonadhäsionsmittel nach seiner Verdünnung mit Lösungsbenzin oder einem anderen Lösemittel angewendet werden.

Um die Silikonmischung auszutreiben, wird eine Polyurethanmatrize mit einem darauf aufgetragenem Silikon zuerst gebogen und dann in ihrem gewölbten Teil in Kontakt mit dem Glas gebracht. Danach wird die Matrize geradegebogen, bis ein vollständiger Kontakt mit dem Glas über die gesamte Oberfläche der Matrize sichergestellt ist.

Die Silikonpolymerisation der Linsenplatte wird bei einer Temperatur von 15 - 60 °C im Laufe von 0,5 - 48 Stunden durchgeführt.

Die Verbundlinsenplatte (Glas-Silikon) gemäß der Erfindung wird nach dem Polymerisationsverfahren der Zweikomponenten-Silikonmischung zwischen dem Glas und der Polyurethanmatrize der negativen Fresnel-Linsen gefertigt.

Das Fixieren der Silikon-Fresnel-Linsen am Glas erfolgt unter Einsatz einer Adhäsionsmittelschicht (Primer), die auf das Glas aufgetragen wird.

Zur Herstellung einer Zwischenlinsenplatte und der Linsenplatte, die als optischer Sonnenlichtkonzentrator dient, wurde eine Zweikomponenten-Silikonmischung gewählt. Diese Zweikomponenten-Silikonmischung weist eine hohe Durchsichtigkeit im Bereich des optischen Spektrums von 350 - 2000 nm, lange Standzeiten und eine Beständigkeit gegen Sonnenstrahlung und Umwelteinwirkung sowie eine sehr geringe Schrumpfung nach der Polymerisation (in der Größenordnung von 0,1 %) auf. Das stellt eine maximal mögliche Qualität der gefertigten Fresnel-Linsen sicher.

Der Einsatz von Polymethylmethakrylat oder einem beliebigen korrosionsbeständigen Metall als Material für die negativen Fresnel-Linsen, die mittels Diamantdrehens gefertigt werden, stellt eine hohe optische Qualität des Profils der Fresnel-Linsen sicher.

Als Material für die Matrizen wird Polyurethan der Marke Por-A-Kast M15 oder ein beliebiges Polyurethan mit einer Gesamtschrumpfung (in allen Abmessungen) nach der Polymerisation von max. einigen Prozentbruchteilen verwendet. Die Mischungspolymerisation wird im Laufe von 3 - 48 Stunden bei einer Temperatur von 20-50 °C durchgeführt. Die Auswahl eines solchen Materials stellt eine hohe Reproduktionsgenauigkeit des negativen Profils der Fresnel-Linsen sicher. Die vorgegebenen Zeit- und Temperaturintervalle sorgen für eine Polymerisation ohne jegliche merkliche Temperaturausdehnung und folglich ohne bemerkbare Verformung des negativen Profils der Fresnel-Linsen. Dieses Material ist für die Herstellung von hochpräzisen Kopien von unterschiedlichen Bauteilen konzipiert.

Die Beschichtung der Glasoberfläche mit Primer stellt eine zuverlässige Haftung der Silikonmischung mit dem positiven Profil der Fresnel-Linsen zum Silikatglas nach der Polymerisation sicher, was eine lange Standzeit der gefertigten Linsenplatte gewährleistet.

Die Silikonpolymerisation der Linsenplatte wird bei einer Temperatur von 15 - 60 °C im Laufe von 0,5 - 48 Stunden durchgeführt. Diese Zeit- und Temperaturintervalle stellen die Polymerisation der Silikonmischung ohne jegliche merkliche Temperaturausdehnung und folglich ohne bemerkbare Formänderung des positiven Profils der Fresnel-Linsen sicher.

Das Verfahren zur Herstellung einer Konzentratorlinsenplatte aus Verbundstoff für photoelektrische Module wird anhand von Ausführungsbeispielen in den Zeichnungen näher erläutert. Es zeigen:
Fig. 1 die Reihenfolge der Arbeitsgänge zur Herstellung einer Polyurethanmatrize mit negativen Fresnel-Linsen und
Fig. 2 die Reihenfolge der Arbeitsgänge zur Herstellung einer Linsenplatte.

Das Verfahren zur Herstellung einer Linsenplatte für photoelektrische Module wird in folgender Weise ausgeführt.

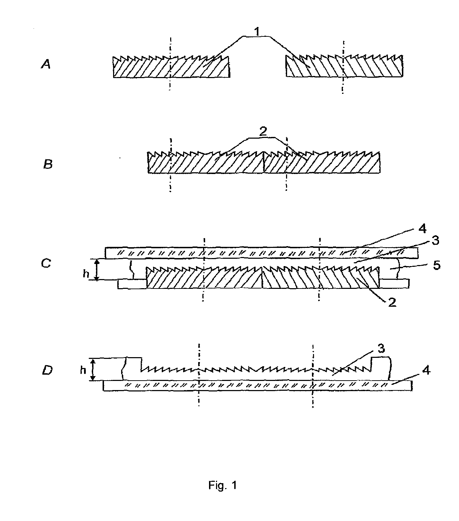

### Arbeitsgang A (Fig. 1)

Die Herstellung von einem Anfangssatz von negativen (mit negativem Fokusabstand) Fresnel-Linsen mit einer quadratischen Apertur nach dem Diamant-Mikrodreh-Verfahren mit Polymethylmethakrylat oder Metall 1. Die Anzahl von solchen negativen Linsen entspricht der vorgegebenen Anzahl der Linsen in der herzustellenden Linsenplatte.

Die Strichpunktlinien zeigen die optischen Linsenachsen an.

### Arbeitsgang B (Fig. 1)

Die quadratischen Negativmatrizen werden an ihren Stirnseiten zu einer Baugruppe 2 zusammengebaut.

### Arbeitsgang C (Fig. 1)

Die Herstellung einer Zwischenplatte mit positiven Fresnel-Linsen. Dafür wird eine Zweikomponenten-Silikonmischung 3 unter Zusatz von einem platinhaltigen Katalysator zwischen einem Glas 4 oder einem flexiblen mit dem Primer vorher beschichteten Blattmaterial (zum Beispiel plattiertes Glasfaserhartgewebe) und der Baugruppe 2 mit negativen Matrizen ausgegossen und zur Polymerisation gebracht.

Entlang der Außenreihen der Baugruppe 2 werden Vertiefungen vorgesehen, die für eine Ausbildung von Silikon-Seitenvorsprüngen 5 beim Ausgießen der Silikonmischung 3 sorgen. Die Vorsprungshöhe beträgt h > 1 mm. Die Silikonpolymerisation wird im Laufe von 1 - 10 Stunden bei einer Temperatur von 20 - 50 °C durchgeführt.

### Arbeitsgang D (Fig. 1)

Eine Trennung der Zwischenplatte 3 auf dem Glas 4 von der Baugruppe 2. Die Zwischenplatte 3 auf dem Glas 4 mit positiven Fresnel-Linsen ist eine Einwegform für die Herstellung einer Polyurethanmatrize mit negativen Fresnel-Linsen.

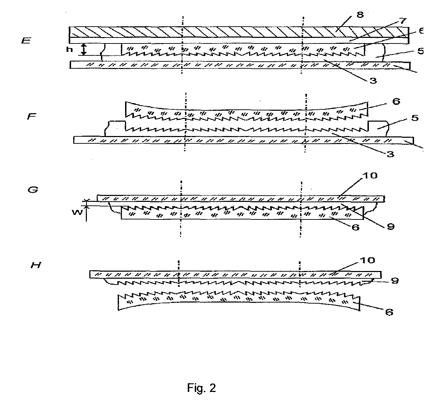

### Arbeitsgang E (Fig. 2)

Das Kopieren (Nachbildung) der Zwischenplatte 3 mit positiven Fresnel-Linsen, indem eine negative Matrize 6 aus schrumpfarmen Zweikomponenten-Polyurethan gegossen wird. Dafür wird das vorher vermischte Zweikomponenten-Polyurethan in die Vertiefungen der Zwischenplatte 3 mit positiven Silikon-Fresnel-Linsen so gegossen, dass die PUR-Mischung 6 den Umfang der Einwegform völlig ausfüllt und eine überschüssige Schicht ausbildet. Diese überschüssige Schicht muss über die Oberfläche der Seitenvorsprünge 5 um eine Höhe von mindestens 0,1 mm hinausragen. Um eine Reproduzierbarkeit der optischen Qualität der Fresnel-Linsen-Oberflächen sicherzustellen, muss ein Polyurethan mit einem Schrumpfungsgrad von max. 0,2 % eingesetzt werden. Polyurethan der Marke Por-A-Kast M15 erfüllt diese Voraussetzung. Nach dem Ausgießen erfolgt ein Vakuumpumpen im Laufe von einigen Minuten, um Luftblasen aus der Polyurethanmischung und besonders von der Oberfläche des Fresnel-Profils auf der Zwischenlinsenplatte zu entfernen. Die Abpumpkammer enthält einen zusätzlichen 3 - 4 cm hohen Raum für das Platzen der Luftblasen, die aus der Polyurethanmischung während des Abpumpens entweichen. Das Abpumpen wird unter Einsatz einer Vorpumpe durchgeführt, deren Leistung dafür ausreicht, die Kammer bis zu einem Restdruck von 10⁻² Topp innerhalb von nur einigen Minuten abzupumpen.

Nach dem Abpumpen wird auf die ausgefüllte Form mit der Polyurethanmischung ein Blatt (eine Platte) 7 aus einem flexiblen Material (Plexiglas, Glashartgewebe und a.m.) aufgelegt. Das Blatt 7 wird dann mit einer Platte 8 aus hartem Material abgedeckt. Die überschüssige Menge der Polyurethanmischung wird aus der Form gleichmäßig ausgetrieben, um eine Polyurethanschicht mit gleicher Dicke zu erhalten. Dieses Ausquetschen wird so lange durchgeführt, bis das flexible Blatt 7 mit den Seitenvorsprüngen 5 an der Zwischenplatte 3 mit positiven Fresnel-Linsen in Kontakt kommt. Damit wird eine gleichmäßige Dicke der Polyurethanmatrize 6 sichergestellt. Diese Dicke fällt mit der Dicke h der Vorsprünge 5 zusammen.

Danach erfolgt eine Polymerisation der Polyurethanmischung im Laufe von 3-24 Stunden bei einer Temperatur von 20 - 50 °C.

### Arbeitsgang F (Fig. 2)

Die Polyurethanmatrize 6 wird von der Zwischenplatte 3 mittels Biegung der Polyurethanmatrize 6 abgelöst.

### Arbeitsgang G (Fig. 2)

Um die Linsenplatte herzustellen, wird die Polyurethanmatrize 6 mit einer Zweikomponenten-Silikonmischung 9 unter Zugabe eines platinhaltigen Katalysators gefüllt. Die Dicke W der Silikonmischung 9 über den Vorsprüngen 5 der Polyurethanmatrize 6 beträgt mehr als 0,1 mm.

Danach wird die Oberfläche der Silikonmischung 9 mit einer Platte 10 aus Silikatglas abgedeckt. Die Übermenge der Silikonmischung 9 wird ausgetrieben, bis eine Schichtdicke von mindestens 0,1 mm erreicht wird.

Danach erfolgt eine Polymerisation der Silikonmischung 9 bei einer Temperatur von 20 °C < T < 50 °C im Laufe von 1 - 10 Stunden.

### Arbeitsgang H (Fig. 2)

Die mittels Polymerisation der Silikonmischung gefertigte Linsenplatte 9 wird zusammen mit der Glasplatte 10 von der Polyurethanmatrize 6 abgetrennt, indem die Polyurethanmatrize 6 gebogen wird.

Nachstehend werden Ausführungsbeispiele des Verfahrens beschrieben.

### Beispiel 1

Die mittels Diamant-Mikrodrehens gefertigten Negativmatrizen der Fresnel-Linsen mit einer quadratischen Apertur von 40 x 40 mm werden zu einer Baugruppe 2 mit 12 x 12 Linsen zusammengefügt, wobei sie an ihren Seitenflächen miteinander verbunden werden. Das Fresnel-Profil ist nach oben ausgerichtet. Und die Böden der Negativmatrizen sind auf einer ebenen Oberfläche befestigt. An den Seiten der äußeren Negativmatrizen wird eine Vertiefung von 3 - 7 mm ausgebildet, um Seitenvorsprünge 5 aus Silikon zu bilden. Die Mischung von einem schrumpfarmen Zweikomponenten-Silikon der Marke Wacker Elastosil RT604 oder Dow corning Sylgard 184 mit der Zugabe eines platinhaltigen Katalysators wird auf die Oberfläche einer solchen Baugruppe 2 mit Negativmatrizen gegossen. Diese zusammengebaute Baugruppe 2 wird von oben mit Silikatglas 4 oder mit einem flexiblen mit einem Primer vorbeschichteten Blattmaterial 7 abgedeckt. Danach wird die überschüssige Silikonmischung ausgetrieben, bis die Silikonmischung eine Dicke von 0,1 - 0,5 mm erreicht und bis die Vertiefungen für die Ausbildung der Seitenvorsprünge 5 mit der Silikonmischung völlig ausgefüllt sind. Die Polymerisation der Silikonmischung zwischen den Negativmatrizen und dem Glas 4 oder dem flexiblen Blattmaterial 7 kommt zustande. Die Polymerisation erfolgt bei einer Temperatur von 15 - 50 °C bis zur vollständigen Polymerisation der Silikonmischung. Dann wird das Glas 4 oder das flexible Blattmaterial 7 von den zusammengebauten Negativmatrizen der Fresnel-Linsen abgelöst. Somit wird eine Zwischenlinsenplatte mit positiven Fresnel-Linsen gefertigt. Danach wird die Polyurethanmischung der Marke Por-A-Kast M15 auf die Oberfläche der Zwischenplatte mit den gefertigten positiven Fresnel-Linsen gegossen. Beim Ausgießen tritt die Polyurethanmischung oberhalb der Seitenvorsprünge 5 um 3 bis 5 mm hervor. Die Seitenvorsprünge 5 werden an den Rändern der Zwischenlinsenplatte ausgebildet. Danach wird die Polyurethanmischung in einer Abpumpkammer abgepumpt. Diese Abpumpkammer wird über der mit Polyurethan ausgegossenen Form mit der Zwischenlinsenplatte angeordnet. Das Abpumpen erfolgt im Laufe von einigen Minuten bis alle Blasen in der Polyurethanmischung zerplatzt sind. Danach wird die Abpumpkammer entfernt. Die Polyurethanmischung wird mit einem flachen flexiblen Blatt 7 mit glatter Oberfläche (Plexiglas) abgedeckt. Obendrauf wird eine Platte 8 aus einem Hartmaterial aufgelegt. Die überschüssige Polyurethanmischung wird ausgepresst, bis ein Kontakt mit den Seitenvorsprüngen 5 der Zwischenlinsenplatte erreicht ist. Danach kommt eine Polymerisation der Polyurethanmischung bei Raumtemperatur innerhalb von 48 Stunden zustande. Nach der Polymerisation wird die Polyurethanmatrize 6 von der Zwischenlinsenplatte abgetrennt. Dafür wird entweder das Polyurethan (wenn die Zwischenlinsenplatte auf Glas 4 ausgebildet ist) oder das flexible Blattmaterial 7 (wenn die Zwischenlinsenplatte auf dem flexiblen Blattmaterial 7 ausgebildet ist) gebogen. Im Endeffekt wird eine negative integrierte Matrize aus Fresnel-Linsen fertig gestellt. Sie ist aus 12 x 12 Matrizen mit einer Apertur von 40 x 40 mm zusammengebaut.

Diese negative Polyurethanmatrize 6 wird zur mehrfachen Herstellung von Linsenplatten mit 12 x 12 positiven Fresnel-Linsen mit einer Apertur von 40 x 40 mm eingesetzt (Wiederverwendungsmatrize). Die Mischung von dem schrumpfarmen Silikon der Marke Wacker Elastosil RT604 oder Dow corning Sylgard 184 oder von einem anderen beliebigen Silikon mit ähnlichen Eigenschaften mit der Zugabe des platinhaltigen Katalysators wird auf die Oberfläche der negativen integrierten Matrize gegossen. Obendrauf wird das vorher mit Primer beschichtete Silikatglas 4 mit einem niedrigem Eisengehalt (z.B. Optiwhite der Fa. Pilkington) aufgelegt. Das Silikon wird so lange ausgepresst, bis es die Oberfläche der negativen Matrize 6 gleichmäßig ausfüllt und bis die Silikonschichtdicke zwischen dem Glas 4 und der Matrize 0,1 - 0,2 mm beträgt. Die Silikonpolymerisation erfolgt bei einer Temperatur von 40 °C im Laufe von 20 Stunden. Nachdem die Polymerisation beendet ist, wird das Glas 4 von der Negativmatrize abgetrennt, indem die Matrize 6 gebogen wird. Somit wird eine Linsenplatte des optischen Konzentrators aus 12 x 12 positiven Fresnel-Linsen mit einer Apertur von 40 x 40 mm gefertigt. Diese Linsenplatte wird nachher beim Zusammenbau des photoelektrischen Moduls mit 12 x 12 Solarzellen angewendet. Dabei werden die Solarzellen an der gemeinsamen Wärmeabführung befestigt und sind darüber hinaus im Fokus der 12 x 12 Fresnel-Linsen angeordnet. Die negative Polyurethanmatrize wird danach zur mehrfachen Herstellung der Linsenplatten wieder verwendet. Diese Linsenplatten zeichnen sich durch eine hohe optische Qualität und Reproduzierbarkeit aus.

### Beispiel 2

Der Unterschied zum Beispiel 1 besteht darin, dass die Dicke der Silikonmischung zwischen dem Silikatglas 4 und den höchsten zähneartigen Vorsprüngen 5 der negativen Fresnel-Linse in der Polyurethanmatrize 0,1 mm beträgt. Der weitere Unterschied zum Beispiel 1 besteht darin, dass die Polymerisation der Polyurethanmischung bei einer Temperatur von 20 °C im Laufe von 48 Stunden zustande kommt, und dass die Silikonmischung bei der Herstellung von der Zwischenlinsenplatte und der Linsenplatte des optischen Konzentrators mit einer größeren Menge eines platinhaltigen Katalysators ergänzt wird, und die Silikonpolymerisation im Laufe von 0,5 Stunden bei einer Temperatur von 60 °C erfolgt.

### Beispiel 3

Der Unterschied zum Beispiel 1 besteht darin, dass die Dicke der Silikonmischung zwischen dem Silikatglas 4 und den höchsten zähneartigen Vorsprüngen 5 der negativen Fresnel-Linse in der Polyurethanmatrize 10 mm beträgt. Der weitere Unterschied zum Beispiel 1 besteht darin, dass die Polymerisation der Polyurethanmischung bei einer Temperatur von 50 °C im Laufe von 3 Stunden, zustande kommt, und dass die Silikonmischung bei der Herstellung der Zwischenlinsenplatte und der Linsenplatte des optischen Konzentrators mit einer geringeren Menge des platinhaltigen Katalysators ergänzt wird, und die Silikonpolymerisation im Laufe von 48 Stunden bei einer Temperatur von 15 °C erfolgt.

Um eine große Menge von Linsenplatten herzustellen, sind sehr viele negative Polyurethanmatrizen erforderlich. Deswegen werden die unter B bis F, Fig. 1 und 2 angegebenen Arbeitsgänge mehrfach wiederholt. Die erste zusammengebaute Baugruppe 2, die mittels Diamant-Drehens der negativen Linsen hergestellt wurde, ermöglicht es, mehr als ein Tausend von negativen Polyurethanmatrizen 6 mit hoher Qualität anzufertigen. Dabei stellt jede Matrize 6 ihrerseits bei mehrfacher Wiederholung der Arbeitsgänge G und H die Herstellung von über ein Tausend Linsenplatten sicher. Somit ergibt nur ein Satz der mittels Diamant-Drehens hergestellten Linsen die Herstellung von über 1 Mio. Linsenplatten nach dem vorgeschlagenen Verfahren. Das stellt bei der Fläche der Linsenplatte von z. B. 0,25 m² die Herstellung von Solar-Konzentratormodulen mit einer Gesamtendleistung von über 25 MW pro Jahr sicher.

Die Massenproduktion von Verbundstofflinsenplatten aus einer Silikonmischung mit einer Glasunterlage bedarf einer flexiblen kostengünstigen Matrize der negativen Fresnel-Linsen. Die nach dem Verfahren des Diamant-Mikrodrehens gefertigten Negativmatrizen weisen eine hohe Präzision der optischen Oberflächen auf. Dafür sind sie sehr teuer und setzen einen großen Zeitaufwand bei ihrer Herstellung voraus. Die nach dem Kunststoffpressverfahren bzw. nach dem Druckgussverfahren hergestellten negativen Kunststoff-Fresnel-Linsen haben eine niedrigere Qualität der optischen Oberflächen im Vergleich zu den mittels Diamant-Mikrodrehens gefertigten Negativlinsen. Das vorgeschlagene Verfahren ermöglicht es, in einem Arbeitsablauf viele Linsenplatten mit Hilfe von nur einem Anfangssatz von negativen mittels Diamant-Mikrodrehens gefertigten Fresnel-Linsen herzustellen.

Das vorgeschlagene Verfahren zur Herstellung einer Konzentratorlinsenplatte aus Verbundstoff für photoelektrische Module ermöglicht es, die Produktivität und die Wirtschaftlichkeit bei Herstellung von Linsenplatten sicherzustellen und gleichzeitig lange Standzeiten und hohe optische Güte der Fresnel-Linsen zu erreichen.

## Patentansprüche

1. Verfahren zur Herstellung einer Konzentratorlinsenplatte aus Verbundstoff für photoelektrische Module, das die Herstellung von negativen Fresnel-Linsen und die Fertigung von positiven Kopien derselben einschließt,
**dadurch gekennzeichnet,**
**dass** mittels Diamantdrehens hergestellte negative Fresnel-Linsen mit quadratischer Apertur an ihren Stirnseiten miteinander zu einer Baugruppe (2) zusammengefügt werden,
**dass** danach eine Zwischenplatte gefertigt wird, indem die zusammengebaute Baugruppe (2) mit den negativen Fresnel-Linsen und einem über der Baugruppe (2) angeordneten Silikatglas (4) oder einem flexiblen Blattmaterial (7) und einer Zweikomponentensilikon-Mischung (3) ausgegossen wird,
**dass** danach eine Polymerisation der Zweikomponentensilikon-Mischung (3) durchgeführt wird,
**dass** die Zwischenplatte von der zusammengebauten Baugruppe (2) mechanisch getrennt und danach auf die Polyurethanmatrize kopiert wird, wobei das im Raum zwischen der Zwischenplatte und dem flachen Blattmaterial (7) befindliche Zweikomponentenpolyurethan polymerisiert wird,
**dass** die hergestellte Polyurethanmatrize nach ihrem Biegen abgelöst, danach auf einer harten Grundlage befestigt und mit einer Zweikomponentensilikon-Mischung (3) gefüllt wird,
**dass** die Dicke der Zweikomponentensilikon-Schicht (3) um mindestens 0,1 mm größer als die jeweilige Höhe der Profileinsenkungen der Fresnel-Linsen in der Polyurethanmatrize gewählt ist und dabei über dem Silikon das Silikatglas (4) mit einem auf seiner Oberfläche aufgetragenen Primer angeordnet ist,
**dass** die Übermenge der Zweikomponentensilikon-Mischung (3) ausgepresst wird, bis eine Schichtdicke von mindestens 0,1 mm erreicht ist und
**dass** danach die Zweikomponentensilikon-Mischung (3) polymerisiert und das Glas (4) mit der Linsenplatte durch Biegen von der Polyurethanmatrize abgetrennt wird.

2. Verfahren zur Herstellung einer Konzentratorlinsenplatte aus Verbundstoff für photoelektrische Module nach Anspruch 1,
**dadurch gekennzeichnet,**
**dass** als Material für die negativen mittels Diamantdrehens gefertigten Fresnel-Linsen ein Polymethylmethakrylat oder ein beliebiges korrosionsbeständiges Metall verwendet wird.

3. Verfahren zur Herstellung einer Konzentratorlinsenplatte aus Verbundstoff für photoelektrische Module nach Anspruch 1,
**dadurch gekennzeichnet,**
**dass** als Material für die Matrize Polyurethan der Marke Por-A-Kast M15 oder ein beliebiges Polyurethan mit einer Gesamtschrumpfung nach der Polymerisation von maximal einigen Prozentbruchteilen verwendet wird und
**dass** die Mischungspolymerisation im Laufe von 3 - 48 Stunden bei einer Temperatur von 20 bis 50 °C durchgeführt wird.

4. Verfahren zur Herstellung einer Konzentratorlinsenplatte aus Verbundstoff für photoelektrische Module nach Anspruch 1,
**dadurch gekennzeichnet,**
**dass** als Primer ein Primer Wacker oder ein beliebiges anderes Grundierungsmittel eingesetzt wird, welches für die Oberflächenbehandlung und für die Sicherstellung einer Adhäsion der Silikonelastomere vorgesehen wird.

5. Verfahren zur Herstellung einer Konzentratorlinsenplatte aus Verbundstoff für photoelektrische Module nach Anspruch 1,
**dadurch gekennzeichnet,**
**dass** als Primer ein transparentes Einkomponenten-Silikonadhäsionsmittel nach seiner Verdünnung mit Lösungsbenzin oder einem anderen Lösungsmittel verwendet wird.

6. Verfahren zur Herstellung einer Konzentratorlinsenplatte aus Verbundstoff für photoelektrische Module nach Anspruch 1,
**dadurch gekennzeichnet,**
**dass** zum Austreiben der Silikonmischung die Polyurethanmatrize mit einem darauf aufgetragenen Silikon zuerst gebogen wird und
**dass** der gewölbte Teil nachher in Kontakt mit dem Glas (4) gebracht und dann geradegebogen wird, um einen vollständigen Kontakt mit dem Glas (4) über die gesamte Oberfläche der Polyurethanmatrize sicherzustellen.

7. Verfahren zur Herstellung einer Verbundstofflinsenplatte für photoelektrische Module nach Anspruch 1,
**dadurch gekennzeichnet,**
**dass** die Silikonpolymerisation der Linsenplatte bei einer Temperatur von 15 bis 60 °C im Laufe von 0,5 bis 48 Stunden durchgeführt wird.
